(19) Europäisches Patentamt
European Patent Office
Office européen des brevets

(11) **EP 0 637 400 B1**

(12) **EUROPEAN PATENT SPECIFICATION**

(45) Date of publication and mention
of the grant of the patent:
**09.10.1996 Bulletin 1996/41**

(21) Application number: **93912262.8**

(22) Date of filing: **21.04.1993**

(51) Int Cl.6: **H01G 4/18**, C23C 14/20,
C08J 5/18

(86) International application number:
**PCT/US93/03562**

(87) International publication number:
**WO 93/22779 (11.11.1993 Gazette 1993/27)**

(54) **ULTRA-THIN LOW MOISTURE CONTENT POLYESTER FILM AND ITS APPLICATIONS**

ULTRADUENNER POLYESTERFILM MIT NIEDRIGEM FEUCHTIGKEITSGEHALT UND SEINE ANWENDUNG

FILM POLYESTER ULTRA-MINCE RENFERMANT PEU D'HUMIDITE ET APPLICATIONS DE CE DERNIER

(84) Designated Contracting States:
**BE DE GB IT**

(30) Priority: **23.04.1992 FR 9204995**

(43) Date of publication of application:
**08.02.1995 Bulletin 1995/06**

(73) Proprietor: **E.I. DU PONT DE NEMOURS AND COMPANY**
**Wilmington Delaware 19898 (US)**

(72) Inventors:
• **BERTRAND, René, Lucien**
**F-57400 Angevilliers (FR)**
• **GABLER, Klaus, Helmut**
**L-8078 Bertrange (LU)**
• **MICHELS, Bernard, Jean**
**L-2412 Howald (LU)**
• **NICOLAI, Luc, Marie**
**B-6700 Arlon (BE)**

(74) Representative: **Hirsch, Marc-Roger**
**Cabinet Hirsch**
**34 rue de Bassano**
**75008 Paris (FR)**

(56) References cited:
**EP-A- 0 225 631**

• **PATENT ABSTRACTS OF JAPAN vol. 013, no. 546 (C-661) 6 December 1989 & JP-A-12 23 131**
• **DATABASE WPI Section Ch, Week 7830, Derwent Publications Ltd., London, GB; Class A, AN 78-54077A & JP-A-53 067 780**
• **DATABASE WPI Section Ch, Week 7950, Derwent Publications Ltd., London, GB; Class A, AN 79-89981B & JP-A-54 085 252**
• **DATABASE WPI Section Ch, Week 8017, Derwent Publications Ltd., London, GB; Class A, AN 80-30398C & JP-A-55 037 318**
• **DATABASE WPIL Section Ch, Week 8136, Derwent Publications Ltd., London, GB; Class A, AN 81-65345D & JP-A-49 085 145**
• **POLYMER vol. 31, no. 2, February 1990, pp 295-302; FUKUDA ET AL.: 'FTi.r. study on the nature of water sorbed in poly(ethylene terephthalate) film'**

Remarks:
The file contains technical information submitted after the application was filed and not included in this specification

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

The present invention relates to an ultra-thin low moisture content or substantially dry polyester film. It also relates to the applications of such a film and a method of processing during which outgassing takes place, and notably a metallization process, and finally, it relates to metallized films and multi-layer capacitors obtained from such film.

Polyester films, for example, in polyethylene terephthalate (PET) such as Mylar® (DuPont), or in polyethylene naphthalate (PEN) such as those produced by Teijin, are known, along with their applications. Such applications include the use of these polyester films as dielectric material in multi-layer capicators where their use has increased considerably. In such capacitors, a film of metal deposited on the polyester acts as the foil of the capacitor.

There are a very large number of manufacturing processes available. The common link between them is that they involve a step carried out under vacuum in which the virgin polyester film introduced in roll form is unwound, metallized and then wound again onto another core.

In the majority of present-day processes, narrow strips are masked during this metallization step carried out under vacuum, in order to define non-conducting regions referred to as free margins.

The roll of metallized film obtained can then, generally speaking, be treated in two different ways which, this time, are not done under vacuum. A first of such processes consists of unwinding the metallized film, slitting it in the middle of the free margins and then rewinding it in the form of flat rolls referred to as pancakes. Such pancakes are then, in their turn, unwound once again enabling either wound capacitors or what are commonly known as stack capacitors, to be obtained.

A second process consists in unwinding the film which, in this case, is generally metallized on both sides, then covering it with an insulating varnish on one side and then rewinding it onto a drum. Stack capacitors can then be obtained by slitting or guillotining the stack at the middle of the free margins and in the perpendicular direction as well.

The electrical capacity, expressed in Farads, of a multi-layer capacitor is, for a given volume, inversely proportional to the square of the polyester film thickness. This is the reason why there is a heavy demand for ultra-thin film which enable ever-increasing miniaturization to be achieved. There are currently available on the market films which can be as thin as 0.6 microns, and which typically are of the order of one micron thick. Polyester films having a thickness of around 1 micron are however poorly adapted to being treated under vacuum, in a metallizing station, unlike films which are thicker.

It has in fact been noted, somewhat surprisingly, that during unwinding under vacuum, the outer turns of the roll behave in a particular way: they are able to shift sideways with respect to each other in the direction of the axis of the roll causing an offset between layers; this is known as telescoping; the film also suffers from a tendency to "swim", i.e., oscillate laterally about the offset position and, finally, the film tends to expand radially and form wrinkles running in the direction of travel. By way of illustration, four rolls of film 0.9 micron thick and 500 mm wide were observed to suffer from telescoping by an amount of from 1 to 30 mm, from "swimming" with an amplitude of 1 to 10 mm and from formation of wrinkles of a size of from 0.5 to 5 mm.

This behavior with instability and formation of wrinkles is encountered again and/or made more pronounced when the film passes over the transport rolls and over the metallization drum. There are several harmful consequences of such behavior.

Firstly, the roll of metallized film obtained at the end of the process includes wrinkles. Moreover, the turns do not strictly lie one on top of the other but rather are offset axially. Then at the time of slitting, which as has been said, is not done under vacuum, it can obviously be seen that there is a danger of the metallized parts being damaged as a result of the slitting knives coming into contact with them, inevitably leading to reject capacitors. For this reason, the free margins are currently limited to a width of 0.4 mm. Nevertheless, if very low yields are accepted, it is possible to provide free margins of 0.25 mm.

A second harmful consequence is that frequent breakages can occur as the instability is so high. When breakage does occur, it is necessary to re-initialize the metallizer, which is a costly and difficult operation.

A third consequence is that the speed of advancement of the film must be limited to relatively low values so as not to increase the risk of breakage and offset too much. For a thickness of the order of 1 micron, the speed employed is of the order of 1 to 2 meters per second, which could be increased to a figure of 5 meters per second at least if there were no instability, like for conventional thin films of several microns thickness.

Fukuda et al, in "FTIR study on the nature of water sorbed in polyethylene terephthalate film", polymer, 1990, vol.31, February issue, discloses a PET film having a thickness of about 0,76 mm, and which has been held in an oven at 50°C during 4 days, up to dryness.

The present invention surprisingly makes it possible to overcome all these problems, by providing a film as defined in claims 1, 9 and 13. Further, the invention provides the use defined in claim 7, the process defined in claim 10, the capacitor defined in claim 12 and the package defined in claim 14.

## SUMMARY OF THE INVENTION

More precisely, the present invention provides an ultra-thin polyester film of a thickness less than 3 μm as defined in claim 1. In the film, the weakly bound water content is lower than 0.06 weight % based on the weight of polyester. The weakly bound water considered is the water that is not adsorbed but is fully absorbed, this taking place not in the cavities but uniformly, in the body of the polyester. In fact, each water molecule interacts very little with neighboring water molecules and with the polymer chains. The above identified publication "FTIR study on the nature of water sorbed in polyethylene terephthalate film", Polymer, 1990, Vol. 31, February issue provides detailed information on this type of bonding.

The polyester, which is the material of which the present films are made, can be any polyester conventionally used in ultra-thin films. Excellent results have been obtained however with two particular polyesters.

In one embodiment, the polyester is polyethylene terephthalate (PET).

In another embodiment, the polyester is polyethylene naphthalate (PEN).

The thickness of the films according to the present invention is less than or equal to 3 microns, preferably less than 2 μm, and advantageously comprised between 0.4 and 1.4 μm.

The water content of the films according to the present invention expressed in percentage by weight on the basis of the polyester weight is less than 0.06% and, preferably, less than the thickness of the film expressed in microns multiplied by 0.018.

By way of example: For a thickness of 3 microns, the water content is preferably less than 0.054%. For a thickness of 1 micron, the water content is preferably less than 0.018%. For a thickness of 0.5 microns, the water content is preferably less than 0.009%.

The films of the present invention are able to undergo treatment, for example metallization under vacuum, in a ready and fast manner. Thus, speeds can be increased up to 5 to 6 m.s$^{-1}$, and the stability of the film is such that the width of the free margins which initially was 0.4 mm, can be reduced down to 0.1 mm. The films according to the present invention are suitable for use as a dielectric film substrate designed to be metallized either on one or both of its sides with aluminum, zinc, Al/Zn alloy, and other substances. The vacuum used for metallization is variable and is a function of the metal that is to be deposited.

The expression "metallized film" hence covers metallization under vacuum in the wide sense commonly employed by those skilled in the art and is not to be considered as being limited to the metallized films discussed in the example.

The present invention also provides films metallized under vacuum obtained starting from the ultra-thin dry films according to the present invention.

Without wishing to be tied down to any theory, it is believed that the present films obtain their properties thanks to the weakly bound water content, the amount and absorbtion/desorbtion dynamics of which have been neglected to date. Effectively, it is the outgassing of the water contained in the ultra-thin film brought about by the treatment under vacuum which leads to film behaving in a particular way, in other words telescoping, swimming and wrinkling.

Let us consider the case of a conventional polyester film, of a thickness of less than or equal to 3 microns. If this film is kept in air or any other gaseous mixture, the amount of water absorbed is a function of the water vapor partial pressure acting on the film. If this partial pressure is reduced, the film desorbs water automatically until a new equilibrium is reached.

In a temperate climate, the relative humidity of the surrounding air brought, for example, to a temperature of 23°C is generally comprised between 25 and 50%, corresponding to a water vapor partial pressure comprised between 7 and 14 mbar or, stated differently, $7.10^2$ to $14.10^2$ N.m$^{-2}$. For 7 mbar, the water content of the polyester film considered will hence be around 0.125% while, for 14 mbar, this figure will be 0.25%. This linear relation between water content of a polyester film and water partial pressure at 23°C is known and can readily be verified experimentally. It depends neither on the polyester (PET or PEN) nor on the thickness of the film, but is a function of temperature. The temperature is given here as T = 23°C.

Let us now consider that this conventional film, of a thickness less than or equal to 3 microns, in the form of a roll, is introduced into a metallizer and then positioned and subjected to mechanical tensioning. Following this, an air vacuum of $10^{-2}$ to $10^{-4}$ mbar, for example, is provided and after this, the film is driven at a speed of 1 to 2 metres per second, such conditions being those in fact actually used. The total pressure acting on the outer turn of the roll is the pressure prevailing in the metallizer, which, for example, is $10^{-2}$ to $10^{-4}$ mbar, in other words a pressure that is practically zero. The pressure acting on the other turns is given by the formula:

$$Pn \cong \frac{n\sigma e}{R} + Po$$

in which:

n    is the number of the turn, turn 0 being the outermost one of the roll, turn 1 being the one immediately below it, and so on;

Pn   is the pressure exercised on turn n by the (n-1) turns outside it (in N.m$^{-2}$) Po being the pressure prevailing in the metallizer;

σ    is the specific unwinding tension (in N.m$^{-2}$), this being a parameter of the unwinding process;

e =  thickness (expressed in metres);

R =  radius of the roll (expressed in metres).

Conventionally, these values have the following order of magnitude:

σ    is of the order of 2 kilograms-force per square milimeter, in other words $2.10^7$ Newton/m$^2$.

R is generally comprised between 0.20 m (maximum radius at start of unwinding) and 0.08 m (at the end).

By applying the above formula to a 1 micron film, we obtain:

P1 = 1 mbar at the start of unwinding
= 2 mbar at the end of unwinding
P5 = 5 mbar at the start of unwinding
P10 = 10 mbar at the start of unwinding.

For a 3 micron film, we obtain:

P1 = 3 mbar at the start of unwinding
= 7 mbar at the end of unwinding
P3 = 9 mbar at the start of the unwinding, etc.

It will thus be seen that when dealing with a roll of conventional polyester film of thickness less than or equal to 3 microns, and being unwound in a metallizer at a given temperature T, there will always be at least one turn on which there will act a total pressure that is less than or approximately equal to the water vapor partial pressure with which the film was in equilibrium at the same temperature T prior to being put under vacuum and which, as described earlier, is of the order of 7 to 14 mbar for 23°C. Moreover, the speed of absorbtion and desorbtion is, in the case of ultra-thin films, extremely fast, in other words of the order of 1 second, unlike films which are several microns thick for which this constant easily reaches a value of the order of 1 minute. Hence, taking account of the speed of advancement, the length of film characteristically used with this apparatus and the very fast absorbtion/desorbtion, the film undergoes outgassing. Outgassing is always present, at least between the two layers that are outermost. Those layers between which, in this way, a sort of water vapor cushion is set up, are then free to relax and move axially one with respect to the other. Unwinding then becomes unstable.

This phenomenon is all the more important as the speed of outgassing becomes very fast. By way of example, tests have shown that the water content of a PET film 1.2 microns thick changes from 0.25 to 0.02% after being exposed to a water vapor partial pressure of 1 mbar for 1.5 seconds.

The present invention is hence based on the discovery that the problem that needed to be tackled by those skilled in the art is the outgassing of the weakly bound water, this problem not having been appreciated in its full importance to date.

A polyester film of thickness less than or equal to 3 microns will not give rise to stable unwinding under vacuum in a metallizer at a given temperature T unless the water vapor pressure with which the film is in equilibrium prior to being put under vacuum, and at the same temperature T, is preferably less than the minimum value of the expression $n\sigma e/R$ for the first turn (n=1), in other

words $\sigma e/R$ max. In the present case, $\sigma/R$max = $10^8$ N.m$^{-3}$. Hence, if e is expressed in microns, we now have the pressure directly in mbar by simply reading e. For a thickness of 0.5 microns, the water vapor partial pressure with which the film is in equilibrium should hence be preferably less than 0.5 mbar. Also, for one micron, 1 mbar is preferably needed and, for 3 microns, 3 mbar respectively.

If we consider a temperature of 23°C and a ratio $\sigma/R$max of $10^8$ N.m$^{-3}$ the water vapor partial pressures at equilibrium are converted into water content in line with the linear relation given above (for which 14 mbar corresponds to 0.25% of water content in the film), we obtain:

- for a thickness of 0.5 micron, the water content should preferably be less then 0.5 x 0.25:14, in other words 0.009%,
- for a thickness of 1 micron, it should preferably be less than 0.018%,
- for a thickness of 3 microns, it should preferably be less than 0.054%

Generally speaking, the water content, expressed as a percentage by weight, should be preferably less than the thickness of the film expressed in microns multiplied by the number 0.018 (0.25 divided by 14).

In the present specification and claims, the water content is expressed as a weight percentage involving calculation based on defined operating conditions. These conditions are a temperature of 23°C and a ratio $\sigma/R$max of $10^8$ N.m$^{-3}$. Those skilled in the art will readily appreciate that the water content will vary as these parameters vary; nevertheless it is possible to find any equivalent water content value for the above specified values of $\sigma/R$max and temperature when a water content measured under different operating conditions is available.

Polyester films of thickness less than 3 microns, that fulfill this condition, will no longer be subject to instability on the transport and tensioning rolls nor on the metallizing drum.

Effectively, in this case, the total pressure acting on the film and the roll is given by the relation:

$$P = \sigma e/R$$

where R, now, is the radius of the roll.

This pressure is lowest in the case where the metallizing drum has the largest radius. Now, this radius is precisely of the order of the maximum radius that we considered for unwinding, in other words 0.2 meters. Consequently, the films according to this invention, which do not outgas during unwinding, will also not outgas now when passing over the drum.

The outgassing phenomenon which has been highlighted has consequences in other areas apart from metallization under vacuum, this latter being the field in which the technical problem occurred for the first time during unwinding of films to be metallized. It does not only happen under vacuum; at high temperatures, the weakly bound water evaporates and the vaporization dynamics are similar to those obtaining for vacuum conditions. Particularly, in those processes that require mono- or bi-axial stretching, such stretching takes place at a temperature higher than the glass transition temperature Tg of the film and leads to outgassing, in a similar way to the outgassing that happens during metallization under vacuum. The problem that has been discovered is in fact present in all processes that involve an outgassing step. The water contents are then given by relations that are similar to those listed above.

The expression "process involving an outgassing step" means a process in which: firstly, the operating conditions lead to rapid desorbtion, in other words with dynamics involving a speed of several seconds, of weakly bound water present in the polyester film; and secondly, the characteristic process time of the machine in which this process is implemented is also of the order of a few seconds to allow outgassing. Typically, this process or treatment is implemented in production equipment using a length of around one meter and a speed of advancement of around one meter per second.

Thus, the present invention relates to the use of the present films in treatment processes during which an outgassing stage takes place. Preferably, such processes consist of metallization under vacuum, as described previously. Nevertheless, any treatment involving coating is also envisaged: for example, the coating of polyester films with a magnetic material for the manufacture of video or audio tapes.

The present invention also provides films treated as described above, in particular metallized films obtained from film according to the present invention.

The film can be brought to this state of dryness, i. e., 0.06% by weight or less, by any suitable method. Such a method can consist of carrying out manufacture and winding under vacuum, followed by an unwinding-rewinding step under vacuum or at elevated temperature or yet again in a particularly anhydrous atmosphere. Any drying process that leads to outgassing is in fact appropriate. The present invention hence also relates to a process employing a polyester film where an outgassing step is included, further including a predrying step until a weakly bound water content is obtained that is less than 0.06% by weight calculated for the above specified operating condition values of a/Rmax and temperature. Particularly, the present invention relates to films in accordance with the invention in a packaging in which the prevailing atmosphere has a water vapor partial pressure value which is in equilibrium with the film.

The water content is measured as follows: from a roll, a series of rectangular pieces of size 2¼" x 2½" (5.72 cm x 6.55 cm) are cut, which are stacked one on top of the other so as to constitute samples each weighing about 100 g. These samples are weighed very accurately 30 seconds after obtaining them. They are then subjected to high vacuum for at least 90 hours, and are then weighed again immediately after such treatment under vacuum; the relative weight difference is then less than 0.06%.

ILLUSTRATIVE EXAMPLE

A PET film 0.9 µm thick and 500 mm wide was rewound onto a dry core in air at 23°C at a relative humidity of less than 2.9%. The speed the film moved at provided a sufficiently long exposure time to allow the film to outgas. The windup equipment included a lay-on roller in order to limit the quantity of air in the roll.

Under these conditions, the film's water content was of the order of 0.0145% and the problems normally encountered during metallization under vacuum did not appear.

In order to keep the film in its dry state, is was stored as follows. The roll was fitted onto two dry holders. A desiccating medium, such as silica gel or alumina $(A1_2O_3)$ was placed in the two holders as well as at the center of the roll. The roll was wrapped in a film impermeable to water vapor such as a PET-Al-PE film (9 µm, 12 µm, 30 µm) after which it was sealed hermetically.

The amount of desiccant introduced into the packaging should be such that the water vapor partial pressure with which the film is in equilibrium is maintained despite the permeability of the packing.

During metallization under vacuum, the PET film, which was 0.9 µm thick, behaved as follows:

- during unwinding, the virgin film maintained its smooth mirror-like appearance and the surface layers neither telescoped nor showed a tendency to "swim";
- the film did not slide sideways or wrinkle on the transfer rolls;
- increasing the speed of the film did not affect stability which was still perfect even at 5 m.s$^{-1}$.

Thus the present invention makes it possible:

- to significantly improve the stability of free margin super-positioning on the roll of film produced leading to higher production yields since capacitors can only be made from rolls where the free margins lie correctly on top of each other and without creases;
- to decrease the width of the free margin down to a value of 0.1 mm enabling capacitors of an even greater degree of miniaturisation to be manufactured;
- to increase metallization speed and hence output;
- to make metallization possible on thicknesses of submicron size

## Claims

1. Polyester film having a thickness of less than 3 μm and a weakly bound water content lower than 0.06 weight %, based on the weight of polyester, the weakly bound water considered being the water that is fully absorbed, uniformly, in the body of the polyester, and said water content being measured according to the following procedure: cutting a series of rectangular pieces of size 5,72 cm x 6,55 cm, stacking one on top of the other so as to constitute a sample weighing about 100 g, accurately weighing said sample 30 seconds after obtaining it, subjecting said sample to high vacuum for at least 90 hours, and weighing again immediately after such treatment under vacuum; and determining the relative weight difference.

2. Film according to Claim 1, characterized in that the value of the water content, expressed in weight percent, is less than 0,018 times the value of the film thickness, expressed in μm.

3. Film according to Claim 1 or 2, characterized in that said thickness is less than 2 μm.

4. Film according to Claim 3, characterized in that said thickness is comprised between 0,4 and 1,4 μm.

5. Film according to anyone of Claims 1 to 4, characterized in that the polyester is polyethylene terephthalate.

6. Film according to anyone of Claims 1 to 4, characterized in that the polyester is polyethylene naphthalate.

7. Use of the film according to anyone of Claims 1 to 6 in a process wherein outgassing occurs.

8. Use according to Claim 7, wherein said process consists of vacuum metallization of said film.

9. Vacuum metallized film obtained from the film according to anyone of Claims 1 to 6.

10. Process of treatment of a polyester film having a thickness of less than 3 μm, during which an outgassing occurs, wherein prior to the outgassing step, the film is submitted to a drying step so as to obtain a weakly bound water content of less than 0,06 weight %, based on the weight of polyester, the weakly bound water considered being the water that is fully absorbed, uniformly, in the body of the polyester and said water content being measured according to the following procedure: cutting a series of rectangular pieces of size 5,72 cm x 6,55 cm, stacking one on top of the other so as to constitute a sample weighing about 100 g, accurately weighing said sample 30 seconds after obtaining it, subjecting said sample to high vacuum for at least 90 hours, and weighing again immediately after such treatment under vacuum; and determining the relative weight difference.

11. Process according to Claim 10, characterized in that it consists of a vacuum metallization.

12. Multi-layer capacitor obtained from the film according to anyone of Claims 1 to 6.

13. Film according to anyone of claims 1 to 6, provided in roll form.

14. Package containing a film according to anyone of claims 1 to 6 or 13, wherein the partial pressure of water is in hydroscopic equilibrium with the film.

## Patentansprüche

1. Polyesterfolie mit einer Dicke von weniger als 3 μm und einem Gehalt an schwach gebundenem Wasser von weniger als 0,06 Gew.-%, bezogen auf das Gewicht des Polyesters, wobei das berücksichtigte schwach gebundene Wasser das Wasser ist, das gleichmäßig in dem Körper des Polyesters vollständig absorbiert ist, und wobei der Wassergehalt nach dem folgenden Verfahren gemessen wird: Ausschneiden einer Reihe rechteckiger Stücke der Größe 5,72 cm x 6,55 cm, Aufeinanderstapeln, so daß eine Probe mit einem Gewicht von etwa 100 g entsteht, genaues Wiegen der Probe 30 Sekunden, nachdem man sie erhalten hat, wenigstens 90 Stunden Behandeln der Probe im Hochvakuum und erneutes Wiegen im Vakuum unmittelbar nach dieser Behandlung sowie Bestimmen der relativen Gewichtsdifferenz.

2. Folie gemäß Anspruch 1, dadurch gekennzeichnet, daß der Wert des Wassergehalts, ausgedrückt in Gewichtsprozent, geringer ist als 0,018mal der in μm ausgedrückte Wert der Foliendicke.

3. Folie gemäß Anspruch 1 oder 2, dadurch gekennzeichnet, daß die Dicke geringer als 2 μm ist.

4. Folie gemäß Anspruch 3, dadurch gekennzeichnet, daß die Dicke zwischen 0,4 und 1,4 μm liegt.

5. Folie gemäß einem der Ansprüche 1 bis 4, dadurch gekennzeichnet, daß es sich bei dem Polyester um Polyethylenterephthalat handelt.

6. Folie gemäß einem der Ansprüche 1 bis 4, dadurch gekennzeichnet, daß es sich bei dem Polyester um Polyethylennaphthalat handelt.

**7.** Verwendung der Folie gemäß einem der Ansprüche 1 bis 6 bei einem Verfahren, bei dem eine Entgasung auftritt.

**8.** Verwendung gemäß Anspruch 7, wobei das Verfahren aus einer Vakuummetallisierung der Folie besteht.

**9.** Vaküummetallisierte Folie, die aus der Folie gemäß einem der Ansprüche 1 bis 6 erhalten wurde.

**10.** Verfahren zur Behandlung einer Polyesterfolie mit einer Dicke von weniger als 3 μm, bei dem eine Entgasung auftritt, wobei die Folie vor dem Entgasungsschritt einem Trocknungsschritt unterzogen wird, um einen Gehalt an schwach gebundenem Wasser von weniger als 0,06 Gew.-%, bezogen auf das Gewicht des Polyesters, zu erhalten, wobei das berücksichtigte schwach gebundene Wasser das Wasser ist, das gleichmäßig in dem Körper des Polyesters vollständig absorbiert ist, und wobei der Wassergehalt nach dem folgenden Verfahren gemessen wird: Ausschneiden einer Reihe rechteckiger Stücke der Größe 5,72 cm x 6,55 cm, Aufeinanderstapeln, so daß eine Probe mit einem Gewicht von etwa 100 g entsteht, genaues Wiegen der Probe 30 Sekunden, nachdem man sie erhalten hat, wenigstens 90 Stunden Behandeln der Probe im Hochvakuum und erneutes Wiegen im Vakuum unmittelbar nach dieser Behandlung sowie Bestimmen der relativen Gewichtsdifferenz.

**11.** Verfahren gemäß Anspruch 10, dadurch gekennzeichnet, daß es aus einer Vakuummetallisierung besteht.

**12.** Mehrschichtiger Kondensator, der aus der Folie gemäß einem der Ansprüche 1 bis 6 erhalten wurde.

**13.** Folie gemäß einem der Ansprüche 1 bis 6, die in Rollenform bereitgestellt wird.

**14.** Packung, die eine Folie gemäß einem der Ansprüche 1 bis 6 oder 13 enthält, wobei sich der Wasserpartialdruck in hygroskopischem Gleichgewicht mit der Folie befindet.

**Revendications**

**1.** Film polyester ayant une épaisseur inférieure ou égale à 3 microns, et une teneur en eau faiblement liée inférieure à 0,06% en poids par rapport au poids de polyester, l'eau faiblement liée étant considérée comme étant l'eau entièrement absorbée, uniformément, dans la masse du polyester, ladite teneur en eau étant mesurée selon la méthode de la suivante: on découpe, dans un rouleau, une série de morceaux rectangulaires 2"1/4 x 2"1/2 (5,72 cm x 6,55 cm), et on les superpose de façon à constituer des échantillons d'environ 100 g chacune. Ces échantillons sont pesés très précisément 30 secondes après leur obtention. Ils sont ensuite soumis à un vide poussé pendant au moins 90 heures, puis pesés à nouveau immédiatement après ce traitement sous vide, et on détermine la différence relative de poids.

**2.** Film selon la revendication 1, dans lequel la teneur en eau, exprimée en % en poids, est inférieure à l'épaisseur du film exprimée en microns multipliée par le nombre 0,018.

**3.** Film selon la revendication 1 ou 2, dans lequel ladite épaisseur est inférieure à 2 μm.

**4.** Film selon la revendication 3, dans lequel ladite épaisseur est comprise entre 0,4 et 1,4 μm.

**5.** Film selon l'une quelconque des revendications 1 à 4, dans lequel le polyester est du polyéthylénetéréphtalate.

**6.** Film selon l'une quelconque des revendications 1 à 4, dans lequel le polyester est du polyéthylènenaphtalate.

**7.** Application du film selon l'une quelconque des revendications 1 à 6, à un procédé de traitement au cours duquel se produit un dégazage.

**8.** Application selon la revendication 7, dans laquelle ledit procédé de traitement consiste en la métallisation sous vide dudit film.

**9.** Film métallisé sous vide obtenu à partir du film selon une quelconque des revendications 1 à 6.

**10.** Procédé de traitement d'un film polyester d'épaisseur inférieure ou égale à 3 μm au cours duquel se produit une étape de dégazage, dans lequel, préalablement à ladite étape de dégazage, le film est soumis à une étape de séchage jusqu'à obtention d'une teneur en eau faiblement liée inférieure à 0,06% en poids, par rapport au poids de polyester, l'eau faiblement liée étant considérée comme étant l'eau entièrement absorbée, uniformément, dans la masse du polyester, ladite teneur en eau étant mesurée selon la méthode de la suivant: on découpe, dans un rouleau, une série de morceaux rectangulaires 2"1/4 x 2"1/2 (5,72 cm x 6,55 cm), et on les superpose de façon à constituer des échantillons d'environ 100 g chacune. Ces échantillons sont pesés très précisément 30 secondes après leur obtention. Ils sont ensuite soumis à un vide poussé pendant au moins 90 heures, puis pesés à nouveau immédiatement après ce traitement sous vide, et on détermine la différence relative de poids.

11. Procédé selon la revendication 10, caractérisé en ce qu'il consiste en une métallisation sous vide.

12. Condensateurs multicouches obtenus à partir d'un film selon une quelconque des revendications 1 à 6.

13. Film selon l'une quelconque des revendications 1 à 6, présenté sous forme de bobine.

14. Emballage contenant un film selon l'une quelconque des revendications 1 à 6, dans lequel règne une pression partielle de vapeur d'eau avec laquelle le film est en équilibre hygroscopique.